# EUROPÄISCHE PATENTSCHRIFT

(11) **EP 0 961 123 B1**
(45) Veröffentlichungstag und Bekanntmachung des Hinweises auf die Patenterteilung: **14.12.2005**
(21) Anmeldenummer: 99109327.9
(22) Anmeldetag: 28.05.1999
(51) Int. Cl.: G01R 21/133

(54) **Verfahren und Anordnung zur kontinuierlichen und lückenlosen Erfassung, Analyse und Bewertung von Strom- und Spannungssignalen**
Method and apparatus for the continuous detection, analysis and evaluation of current and voltage signals
Procédé et appareil pour la détection, l'analyse et l'évaluation de signaux de courant et de voltage

(30) Priorität: 29.05.1998 DE 19823985
(43) Veröffentlichungstag der Anmeldung: 01.12.1999
(73) Patentinhaber: Maschinenfabrik Reinhausen GmbH, 93059 Regensburg (DE)
(72) Erfinder: Michel, Matthias, Dr., 14471 Potsdam (DE); Liers, Achim, Dr., 14552 Michendorf (DE); Ziemke, Ingo, 98693 Ilmenau-Oberpörlitz (DE)

(56) Entgegenhaltungen:
- EP-A- 0 462 045
- US-A- 4 455 612
- US-A- 5 736 847
- ARAMENDI E ET AL: "System for monitoring the electric power supply system and for voltage and current transients recording" MELECON '96. 8TH MEDITERRANEAN ELECTROTECHNICAL CONFERENCE. INDUSTRIAL APPLICATIONS IN POWER SYSTEMS, COMPUTER SCIENCE AND TELECOMMUNICATIONS. PROCEEDINGS (CAT. NO.96CH35884), PROCEEDINGS OF 8TH MEDITERRANEAN ELECTROTECHNICAL CONFERENCE ON INDUSTRIAL, Seiten 908-912 vol.2, XP002114310 1996, New York, NY, USA, IEEE, USAISBN: 0-7803-3109-5
- GOU J ET AL: "A DSP based real time power quality measurement system" APEC '92. SEVENTH ANNUAL APPLIED POWER ELECTRONICS CONFERENCE AND EXPOSITION. CONFERENCE PROCEEDINGS 1992 (CAT. NO.92CH3089-0), BOSTON, MA, USA, 23-27 FEB. 1992, Seiten 299-302, XP002114311 1992, New York, NY, USA, IEEE, USAISBN: 0-7803-0485-3

## Beschreibung

Die Erfindung betrifft ein Verfahren zur kontinuierlichen und lückenlosen mehrkanaligen Erfassung, Analyse und Bewertung von Strom- und Spannungssignalen zur Beurteilung der Elektroenergiequalität in Nieder-, Mittel- und Hochspannungsnetzen in Echtzeit. Die Ergebnisse können umfassend beurteilt und bewertet und entsprechend den gültigen Vorschriften interpretiert werden.

In den letzten Jahren ist, nicht zuletzt vor dem Hintergrund der Privatisierung von Energieversorgungsunternehmen und deren zunehmendem Wettbewerb untereinander, verstärkt festzustellen, daß an die gelieferte Energie erhöhte Qualitätsanforderungen gestellt werden. Die Versorgungsqualität in Energienetzen wird zunehmend zum Thema; es wird verstärkt von "Spannungsqualität" oder "Power-Quality" gesprochen. Die Aktivitäten im Rahmen von "Power-Quality" sind darauf gerichtet, eine quasi ideale, hochwertige Spannung mit rein sinusförmigem Verlauf mit Grundfrequenz zu liefern.

Unerwünschte Abweichungen von der idealen Spannungsqualität, die ausgeregelt werden müssen, sind insbesondere ein unzulässiger Leistungsfaktor, Störungen und Zusatzverluste. Solche Störungen des Netzbetriebes müssen erfaßt und identifiziert und nachfolgend bewertet werden, um Gegenmaßnahmen einleiten zu können. Dazu ist es notwendig, die Zeitverläufe von Strom und Spannung lückenlos zu erfassen und zu analysieren.

Ein Verfahren und eine Anordnung zu einer solchen Erfassung, Analyse und Bewertung von Strom- und Spannungssignalen ist bereits durch das Analysesystem SIEMOS bekannt; beschrieben in der Firmenschrift "Network Harmonic Analysing System SIEMOS". Bei diesem System erfolgen Messung der jeweiligen Werte einerseits und deren Bewertung andererseits jeweils nacheinander. Es gibt also immer einen Zeitbereich, in dem gemessen wird, dann einen Zeitbereich, in dem berechnet wird, dann wieder einen Zeitbereich, in dem erneut gemessen wird usw. Ein weiteres gattungsgemäßes Verfahren und eine zugehörige Anordnung sind vom Meß-, Registrier- und Störwerterfassungsgerät SIMEAS, beschrieben in der Firmendruckschrift "Analyse der Netzqualität - Oscillostore P513 heißt jetzt SIMEAS N" bekannt. Auch dieses System gestattet keine Echtzeitbewertung. Insgesamt erfolgt nach diesem Stand der Technik die netzsynchrone, mehrkanalige Erfassung der Strom- und Spannungszeitverläufe zeitgleich mit der sich anschließenden Analyse und Bewertung der jeweils zuvor erfaßten Meßgrößen. Verteilte Prozesse auf Signalprozessor-Hardware bilden dazu die Grundlage. Für die jeweiligen Bewertungszeiten konnten keine Erfassungen der Strom- und Spannungswerte erfolgen; diese Zeitbereiche wurden praktisch "ausgeblendet". Dieses bekannte Verfahren ist damit nicht geeignet zur Bewertung schnell veränderlicher Netzvorgänge, wie sie beispielsweise in Stadtwerksnetzen, der Chemieindustrie und besonders an Lichtbogenöfen, bedingt durch Kurzschlüsse und Lichtbogenabrisse, auftreten.

Aus der Veröffentlichung ARAMENDI E ET AL: "System for monitoring the electric power supply system and for voltage and current transients recording" MELECON '96. 8TH MEDITERRANEAN ELECTROTECHNICAL CONFERENCE. INDUSTRIAL APPLICATIONS IN POWER SYSTEMS, COMPUTER SCIENCE AND TELECOMMUNICATIONS. PROCEEDINGS (CAT. NO.96CH35884), PROCEEDINGS OF 8TH MEDITERRANEAN ELECTROTECHNICAL CONFERENCE ON INDUSTRIAL, Seiten 908-912 vol.2, XP002114310 1996, New York, NY, USA, IEEE, USA ISBN: 0-7803-3109-5 ist ein Verfahren zur kontinuierlichen, lückenlosen, mehrkanaligen Erfassung, Analyse und Bewertung von Strom- und Spannungssignalen zur Beurteilung der Elektroenergiequalität bekannt, wobei in jedem Kanal die Schritte zur Analyse und Bewertung von jeweils einem ersten Rechner und einem zugeordneten zweiten Rechner zeit- und aufgabenverteilt durchgeführt werden. Dabei sind die ersten und zweiten Rechner aller Kanäle von einem einzigen dritten Rechner derart gesteuert, dass eine ereignisbezogene Analyse und Bewertung in Echtzeit erfolgen kann.

Aus der EP 0 462 045 A1 ist eine Meßvorrichtung für eine Mehrphasenstromversorgung bekannt, bei der die elektrischen Strom- und Spannungswerte mittels Wandlereinrichtungen umgewandelt werden, danach die gewandelten Strom- und Spannungssignale mittels eines Abtastnetzwerkes abgetastet werden und entsprechende Strom- und Spannungsdigitalabtastsignale abgeleitet werden. Weiter sind Steuermittel vorgesehen, um das beschriebene Abtastnetzwerk zu betätigen und digitale Leistungsverbrauchssignale aus den digitalen Spannungs- und Stromabtastsignalen abzuleiten. Dabei wird das Abtastnetzwerk auf eine solche Weise betätigt, daß innerhalb eines vorgewählten Abtastintervalles mindestens zwei digitale Spannungs- als auch mindestens zwei digitale Stromabtastsignale abgeleitet werden können. Durch eine weitere arithmetische Behandlung werden schließlich impulsförmige Meßausgangssignale erzeugt.

Aus der Veröffentlichung GOU J ET AL: "A DSP based real time power quality measurement system" APEC '92. SEVENTH ANNUAL APPLIED POWER ELECTRONICS CONFERENCE AND EXPOSITION CONFERENCE PROCEEDINGS 1992 (CAT. NO.92CH3089-0), BOSTON, MA, USA; 23-27 FEB. 1992, Seiten 299-302, XP002114311 1992, New York, NY, USA, IEEE, USA ISBN: 0-7803-0485-3 ist ein Echtzeitsystem zur Messung der Energiequalität bekannt, das mit einem digitalen Signalprozessor arbeitet, der wiederum mit einem Computer in Verbindung steht. Das System erfaßt Strom- und Spannungswerte und ermittelt daraus Harmonische, Wirk- und Blindleistung sowie den Leistungsfaktor in Echtzeit.

Aufgabe der Erfindung ist es, ein gattungsgemäßes Verfahren anzugeben, mittels dessen auf besonders einfache Weise die Echtzeiterfassung und Echtzeitbewertung der Strom- und Spannungsverläufe und damit die Bewertung schnell veränderlicher Abläufe möglich ist.

Diese Aufgabe wird durch ein Verfahren mit den Merkmalen des ersten Patentanspruches gelöst. Der Unteranspruch betrifft eine vorteilhafte Weiterbildung des erfindungsgemäßen Verfahrens.

Das erfindungsgemäße Verfahren, realisiert in einer modularen Anordnung, gestattet eine kontinuierliche und lückenlose mehrkanalige Meßung und Bewertung der Strom und Spannungsqualität in Echtzeit ohne Erfassungs- bzw. Bewertungspausen und -unterbrechungen. Die Erfassung der Zeitverläufe für Spannung und Strom kann auf folgende Größen bezogen werden:
- die Ankopplung an die sekundärseitigen Ausgangsgrößen der in den jeweiligen Schaltanlagen installierten Strom- und Spannungswandler
- die direkte niederspannungsseitige Beschaltung mit max. 5 mV - 800 V Spitze/Spitze bzw. 5 mA - 20 A Spitze/Spitze ohne Genauigkeitseinschränkung in der Bitauflösung durch interne Umschaltung der Kanalverstärkung.

Die diskreten Meßsignaleingänge enthalten jeweils eine Potentialtrennung, eine automatische adaptive Stützstellenanpassung, eine Umschaltung auf quarzgenaue Abtastung und einen zusätzlichen Triggereingang zur frequenzselektiven Steuerung der Meß- und Analysefunktionen. Durch die Erfindung sind einsatzabhängig verschiedene Meßaufgaben, wie Transientenrekordermessung, Fallmessung, Störschreiberaufzeichnungen sowie Statistikmessungen möglich.

Die Erfindung gestattet, wie bereits erläutert, eine lückenlose Erfassung der Vorgänge im Netz bei gleichzeitiger Auswertung (Fall-/Statistikmessung) und Massendatenhaltung. Dazu wird ein Mehrprozessorsystem verwendet.

Die Erfindung soll nachfolgend anhand von Zeichnungen beispielhaft noch näher erläutert werden.

Die Figuren zeigen:
- Fig. 1: einen schematischen Ablaufplan eines erfindungsgemäßen Verfahrens
- Fig. 2: eine weitere Ablaufdarstellung dieses Verfahrens, hier den einzelnen Komponenten einer Anordnung zur Durchführung des Verfahrens zugeordnet
- Fig. 3: den prinzipiellen Aufbau einer Kanalkarte dieser Anordnung allein
- Fig. 4: diese Kanalkarte in prinzipieller funktionaler Darstellung
- Fig. 5: den prinzipiellen Gesamtaufbau einer geeigneten Anordnung zur Durchführung des erfindungsgemäßen Verfahrens.

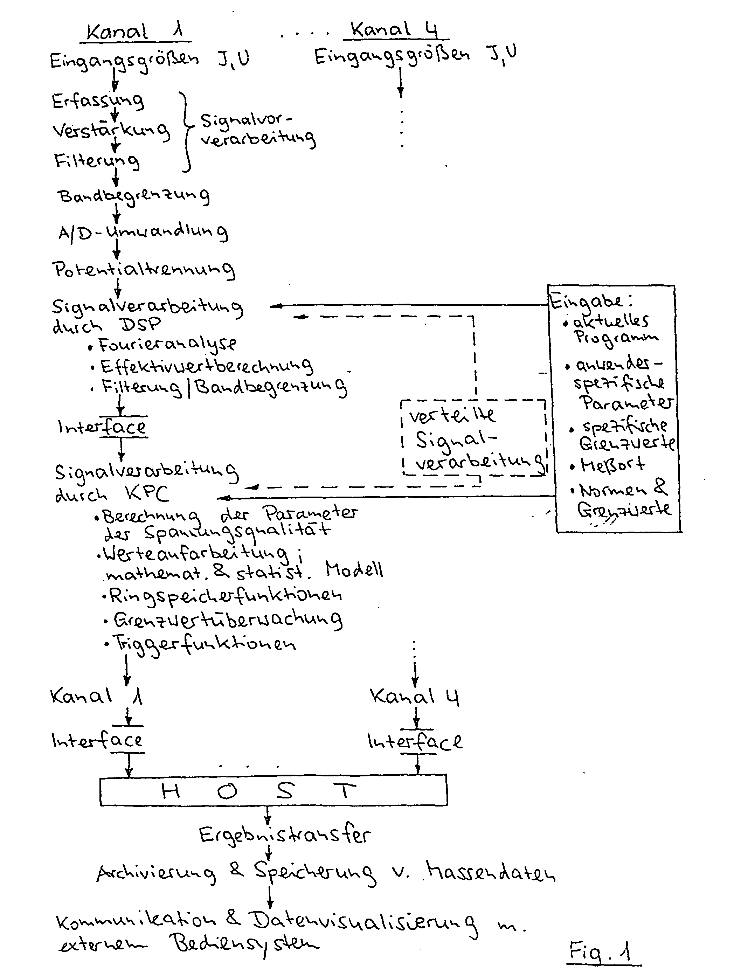

In Fig. 1 sind die wesentlichen nacheinander ablaufenden erfindungsgemäßen Verfahrensschritte schematisch dargestellt. Zunächst erfolgt die Erfassung der Eingangsgrößen von Spannung U und Strom I. Daran anschließend erfolgt jeweils eine Signalvorverarbeitung der erhaltenen Meßsignale, umfassend Verstärkung, Filterung und Bandbreitenbegrenzung; eine solche Signalvorverarbeitung ist an sich bekannt. Im Anschluß daran erfolgt eine Analog/Digital-Umwandlung, vorzugsweise mit mindestens 14 Bit Wandlungsbreite, und nachfolgend eine Potentialtrennung, vorzugsweise eine optische Potentialtrennung. Im Anschluß daran erfolgt die Signalvorverarbeitung durch einen Digitalen Signalprozessor (DSP). Der DSP übernimmt kanalbezogen in Echtzeit die Fourieranalyse, die Effektivwertberechnung und die erweiterte Filterung/Bandbegrenzung (Voraussetzung zur Flickerberechnung).

Die bisher erläuterten Verfahrensschritte können parallel in mehreren Kanälen ablaufen; in der Figur 1 ist nur ein Kanal dargestellt und erläutert.

Die in DSP vorverarbeiteten kanalbezogenen Strom- und Spannungsgrößen werden über ein bidirektionales Interface einem kanalkartenbezogenen Rechner, dem Kartenrechner (KPC), mitgeteilt. Jedem kanalbezogenen DSP ist jeweils ein KPC zugeordnet.

Der Rechner KPC übernimmt die weitere Signalverarbeitung und ist darüber hinausgehend mit Features zur Signalüberwachung ausgestattet. Zur weiterführenden Signalverarbeitung zählen die Berechnung der Parameter der Spannungsqualität sowie die mathematische Werteaufarbeitung für eine umfassende statistische Bewertung der Meßergebnisse.

Zur weiteren Features der kanalbezogenen KPC zählen Funktionen, die den Analogzeitverlauf und/oder die berechneten Meßdaten nach der DSP-Verarbeitung betreffen. Dazu zählen je eine variable Ringspeicherfunktion, frei konfigurierbare Grenzwertüberwachungen und frei programmierbare Triggerfunktionen.

Anschließend erfolgt die Signal- und Ergebnisweitergabe über eine bidirektionale Schnittstelle an einen übergeordneten dritten Rechner, den HOST PC.

Der HOST PC gewährleistet die folgenden Funktionalitäten: Realisierung einer Bedienplattform des Gesamtsystems, Steuerung/Softwaredownload der anwendungssepzifischen Verarbeitungs- und Steuerungssoftware zu den KPC's/DSP's, Ergebnisarchivierung/Maßdatenhandling/Massendatenspeicher der KPC- und HOST-Daten, Ereignisreaktion zu externen Systemen, Kommunikation zu externen Systemen, Datenvisualisierung mit externen Betriebssystemen.

Kernstück des erfindungsgemäßen Verfahrens ist die "Aufgabenteilung" des jeweiligen ersten Rechner DSP mit dem jeweiligen zweiten Rechner KPC innerhalb jedes Kanales und die Steuerung dieser Aufgabenteilung" durch den nachgeschalteten einzigen dritten Rechner, den HOST, mit dem alle zweiten Rechner KPC jeweils parallel zueinander über bidirektionale Schnittstellen in Verbindung stehen. Durch diese zwischen jeweiligen DSP und KPC verteilten Prozesse, die ereignisbezogen durch den HOST gesteuert, d.h. dem jeweiligen Rechner DSP oder KPC "zugewiesen" werden, ist in jedem Fall die Echtzeitfähigkeit gewährleistet. In Fig. 1 ist auch dargestellt, daß es erforderlich ist, den beteiligten Rechnern bestimmte Werte als voreingestellte Sollwerte vorzugeben. Dies sind das jeweilige anwenderspezifische Auswertungsprogramm, die jeweiligen spezifischen Grenzwerte, die jeweils zugrundegelegte Meßart, die bei der Werteaufarbeitung zu berücksichtigenden Normen und Grenzwerte usw.

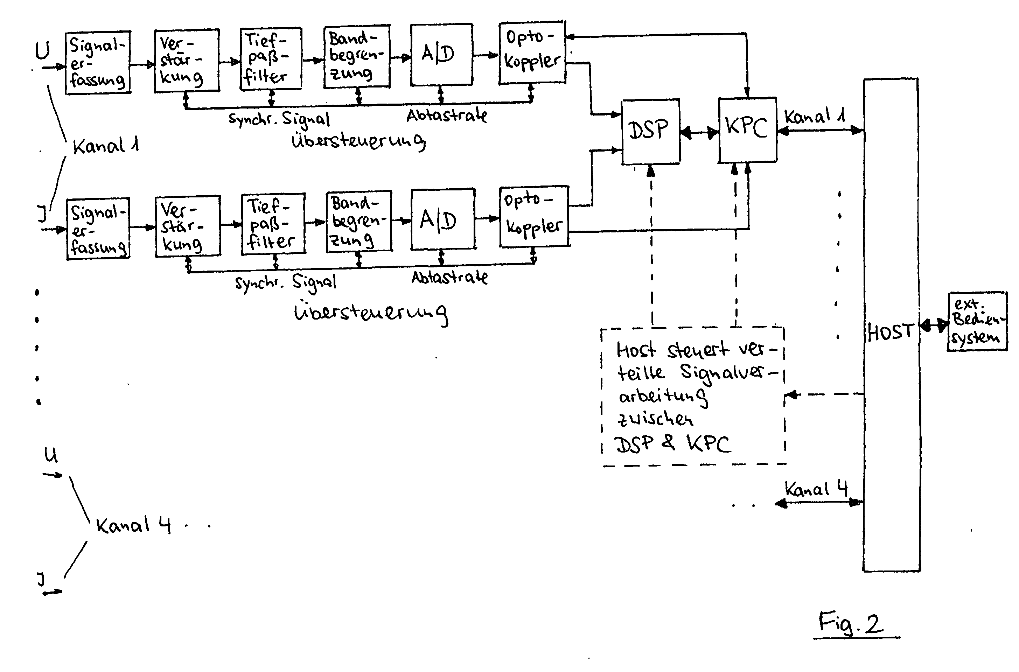

In Fig. 2 ist dieses Verfahren, hier mit 4 Kanälen dargestellt, in Bezug zu den jeweils die Funktion ausübenden Bestandteilen einer Anordnung zur Durchführung des Verfahrens gebracht.

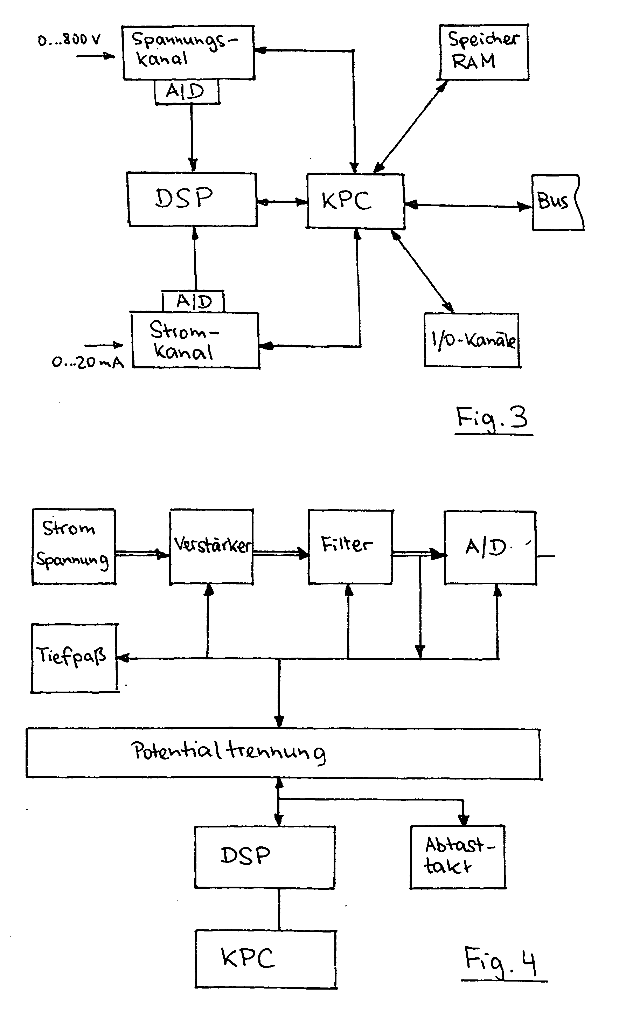

In Fig. 3 ist der prinzipielle Aufbau einer Kanalkarte, d.h. eines einzigen Kanales der in Figur 2 gezeigten Anordnung, dargestellt. Die einzelnen Kanalkarten sind untereinander identisch aufgebaut und softwaretechnisch konfigurierbar. Es existiert jeweils ein Spannungs- und ein Stromkanal mit Potentialtrennung. Jeder Kanalkarte ist ein erster Rechner DSP zugeordnet. Alle Kanalkarten werden jeweils von einem zweiten Rechner, dem Kartenrechner KPC, gesteuert. Die beiden Rechner stehen, wie bereits erläutert, miteinander in Verbindung. KPC übernimmt dabei folgende Funktionen:
- Initialisierung des DSP jeder Karte, Überwachung der Statusmeldungen
- Programmdownload der anwenderspezifischen DSP-Software
- Verstärkungssteuerung im Analogteil jeder Karte auf Potential
- Steuerung der Abtastrate bzw. der adaptiven Stützstellenanpassung zur Meßsignalerfassung
- Kommunikation mit geräteintemem I/O-Bus
- Überwachungsfunktion mit externen I/O-Ereignissen
- Aussteuerungseinstellung der Kanäle, Verstärkungssteuerung
- Berechnung aller statistischen Werte der Spannungsqualität vom DSP
- Reaktion auf Datenanforderungen des Host-PC.

Fig. 4 verdeutlicht noch einmal die funktionalen Zusammenhänge einer Kanalkarte allein. Als KPC ist z.B. ein 32-Bit-Prozessor verwendbar. Die erläuterte Anordnung zur Durchführung des Verfahrens ist aus der oben erwähnten Literaturstelle ARAMENDI E ET AL bekannt.

Bei einer solchen Anordnung wird zur Durchführung des Verfahrens jeweils aus dem Meßsignal über ein Tiefpaßfilter ein Synchronisationssignal für einen Taktgenerator auf der jeweiligen Kanalkarte gewonnen, um eine Abtastrate von 512, 1024, 2048 und 4096 Stützstellen pro Periode der Netzfrequenz zu generieren. Wahlweise können auch quarzstabite Abtastraten generiert werden, die eine Analyse mit konstanter Frequenz gestatten. Jede Kanalkarte kann wahlweise als Signalquelle für die Steuerung des Taktgenerators ausgewählt werden. Neben der Steuerung der Abtastrate ist eine adaptive Stützstellenanpassung zur Meßsignalerfassung möglich.

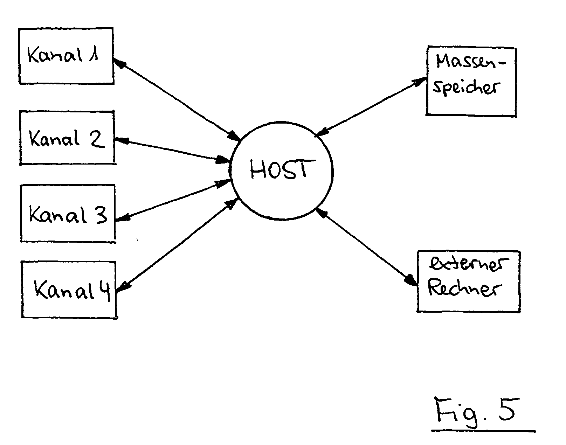

Fig. 5 zeigt den Aufbau der gesamten bekannten Anordnung in schematischer Darstellung; es ist zu sehen, daß hier vier verschiedene Kanalkarten, jeweils enthaltend einen DSP und einen KPC, mit dem HOST in Verbindung stehen. Dieser wiederum ist mit einem Massenspeicher verbunden und kommuniziert mit einem externen Rechner.

Als HOST PC ist etwa ein beliebig konfigurierbares INTEL-Prozessor-System, beispielsweise INTEL Pentium, '586/P133 einsetzbar. In der Figur ist das erfindungsgemäße Mehrprozessorsystem der Anordnung schematisch dargestellt.
Es kommunizieren jeweils erster Rechner DSP und zweiter Rechner KPC jedes Kanales mit dem (einzigen) HOST PC. Der HOST PC übernimmt die bereits beschriebene Fuktionalität wie folgt:
- Realisierung einer Bedienplattform des Gesamtsystems,
- Steuerung/Softwaredownload der anwendungsspezifischen Verarbeitungs- und Steuerungssoftware zu den KPC's/DSP's/Kontrolle der Meß- und Registriermodi,
- kontinuierliche, ergebnisgesteuerte Berechnung von Parametern der Spannungsqualität/dreiphasige Leistungsberechnung,
- Ergebnisarchivierung/Meßdatenhandling/Massendatenspeicherung der KPC- und HOST-Daten/Datenupload nach Triggereintritt,
- Ereignisreaktion zu externen Systemen,
- Kommunikation zu externen Systemen
- Datenvisualisierung mit externen Bediensystemen/Kommunikation zur Meßzeit mit Datenendgerät über eine serielle Verbindung.

Insgesamt ist es durch das erfindungsgemäße Verfahren auf einfache Weise möglich, eine Analyse und Bewertung der Spannungsqualität in Übertragungs-, Verteilungs- und Industrienetzen beliebiger-Spannungsebenen mit schnell veränderlichem Lastcharakter vorzunehmen.

## Patentansprüche

1. Verfahren zur kontinuierlichen und lückenlosen mehrkanaligen Erfassung, Analyse und Bewertung von Strom- und Spannungssignalen zur Beurteilung der Elektroenergiequalität in Nieder-, Mittel- und Hochspannungsnetzen,
bei dem in jedem Kanal die Schritte zur Analyse und Bewertung von jeweils einem ersten Rechner (DSP) und einem zugeordneten zweiten Rechner (KPC) zeit- und aufgabenverteilt durchgeführt werden
und bei dem die ersten und zweiten Rechner (DSP, KPC) aller Kanäle von einem einzigen dritten Rechner (HOST PC) gesteuert werden, derart, daß eine ereignisbezogene Analyse und Bewertung in Echtzeit erfolgt,
**dadurch gekennzeichnet,**
**daß** in jedem Kanal zunächst eine Erfassung der Eingangsgrößen von Spannung U und Strom I erfolgt,
anschließend jeweils eine erste Signalvorverarbeitung der erhaltenen Meßsignale, umfassend Verstärkung, Filterung und Bandbreitenbegrenzung, erfolgt,
nachfolgend jeweils eine Potentialtrennung vorgenommen wird,
anschließend eine zweite Signalvorverarbeitung durch den ersten Rechner (DSP) erfolgt, umfassend eine Fourieranalyse, eine Effektivwertberechnung und eine erweiterte Filterung/Bandbegrenzung,
wiederum nachfolgend die entsprechend der zweiten Signalvorverarbeitung vorverarbeiteten Strom- und Spannungsgrößen über ein bidirektionales Interface, das ersten Rechner (DSP) und zweiten Rechner (KPC) miteinander verbindet, jeweils dem zweiten Rechner (KPC) zugeführt werden, der die nach der zweiten Signalvorverarbeitung im ersten Rechner (DSP) vorverarbeiteten Signale übernimmt und die weitere Signalverarbeitung, umfassend die Berechnung der Parameter der Spannungsqualität sowie eine mathematische Werteaufarbeitung für eine statistische Bewertung der Meßergebnisse, vornimmt
und schließlich die Signal- und Ergebnisweitergabe von allen Kanälen an einen einzigen übergeordneten dritten Rechner (HOST PC) erfolgt, der seinerseits die ereignisbezogene Steuerung aller ersten und zweiten Rechner (DSP, KPC) vornimmt.

2. Verfahren nach Anspruch 1.
**dadurch gekennzeichnet,**
**daß** der einzige dritte Rechner (HOST PC) die Bedienplattform des Gesamtsystems realisiert, eine Ergebnisarchivierung und ein Meßdatenhandling gewährleistet und mit externen Systemen kommuniziert.

## Claims

1. Method for continuous and gap-free multi-channel detection, analysis and evaluation of current and voltage signals for assessment of the electrical energy quality in low, medium and high voltage mains, in which the steps for analysis and evaluation are carried out in each channel distributed in time and task by a respective first computer (DSP) and an associated signal computer (KPC) and in which the first and second computers (DSP, KPC) of all channels are controlled by a single third computer (HOST PC) in such a manner that a result-related analysis and evaluation takes place in real time, **characterised in that** initially a detection of the input magnitudes of voltage U and current I takes place in each channel, subsequently a respective first signal preliminary processing of the obtained measurement signals, comprising amplification, filtering and band width limitation, is carried out, subsequently a respective potential separation is undertaken, subsequently a second signal preliminary processing, comprising a Fourier analysis, an effective value calculation and an expanded filtering/band-limitation, is carried out by the first computer (DSP), further subsequently the current and voltage magnitudes processed in preliminary manner in correspondence with the second signal preliminary processing are respectively fed by way of a bidirectional interface, which interconnects the first computer (DSP) and second computer (KPC), to the second computer (KPC), which takes over the preliminary processed signals after the second signal preliminary processing in the first computer (DSP) and undertakes the further signal processing, comprising calculation of parameters of the voltage quality as well as a mathematical value processing for statistical evaluation of the measurement results, and finally passing on of signals and results from all channels to a single superordinate third computer (HOST PC) takes place, which in turn undertakes result-related control of all first and second computers (DSP, KPC).

2. Method according to claim 1, **characterised in that** the single third computer (HOST PC) realises the operating platform of the entire system, ensures result archiving and measurement data handling and communicates with external systems.

## Revendications

1. Procédé pour la détection, l'analyse et l'évaluation multicanaux continuelles et complètes de signaux de courant et de tension pour juger de la qualité de l'énergie électrique dans les réseaux basse, moyenne et haute tensions, selon lequel
dans chaque canal les étapes d'analyse et d'évaluation sont exécutées de façon répartie en fonction du temps et des tâches par respectivement un premier ordinateur (DSP) et un deuxième ordinateur (KPC) associé, et
les premiers et deuxièmes ordinateurs (DSP, KPC) de tous les canaux sont commandés par un seul troisième ordinateur (HOST PC) de manière à ce qu'une analyse et une évaluation concernant un événement s'effectuent en temps réel,
**caractérisé en ce que**
dans chaque canal s'effectue d'abord une détection des grandeurs d'entrée de la tension U et du courant I,
pour chaque canal un premier prétraitement des signaux de mesure reçus est effectué, comprenant une amplification, une filtration et une limitation de la largeur de bande,
pour chaque canal une séparation de potentiel est effectuée,
ensuite un deuxième prétraitement des signaux est effectué par le premier ordinateur (DSP), comprenant une analyse Fourier, un calcul de la valeur effective et une filtration/limitation de bande supplémentaire,
les grandeurs de courant et de tension prétraitées selon le deuxième prétraitement de signaux sont respectivement transmises par l'intermédiaire d'une interface bidirectionnelle, qui relie le premier ordinateur (DSP) au deuxième ordinateur (KPC) qui reprend les signaux prétraités dans le premier ordinateur (DSP) après le deuxième prétraitement des signaux et effectue le traitement des signaux suivant, comprenant le calcul des paramètres de la qualité de la tension ainsi qu'un traitement des valeurs pour une évaluation statistique des résultats de mesure, et
finalement la transmission des signaux et des résultats de tous les canaux est effectuée à un seul troisième calculateur (HOST PC) de niveau supérieur, qui réalise à son tour la commande en fonction des événements de tous les premiers et deuxièmes ordinateurs (DSP, KPC).

2. Procédé selon la revendication 1,
**caractérisé en ce que**
le seul troisième ordinateur (HOST PC) réalise la plateforme d'utilisation de l'ensemble du système, assure un archivage des résultats et un maniement des données de mesure et communique avec des systèmes extérieurs.
